# EUROPÄISCHE PATENTSCHRIFT

(11) **EP 3 210 325 B1**
(45) Veröffentlichungstag und Bekanntmachung des Hinweises auf die Patenterteilung: **12.12.2018**
(21) Anmeldenummer: 15784395.4
(22) Anmeldetag: 23.10.2015
(51) Int. Cl.: H04L 1/00, H03M 13/15

(54) **VERFAHREN ZUR REKONSTRUKTION EINES IN EINEM DRAHTLOSEN SENSORNETZWERK FEHLERHAFT EMPFANGENEN DATENPAKETS**
METHOD FOR RECONSTRUCTION OF A DATA PACKET RECEIVED WITH ERRORS IN A WIRELESS SENSOR NETWORK
MÉTHODE POUR LA RÉCONSTRUCTION D'UN PAQUET DE DONNÉES REÇU AYANT DES ERREURS DANS UN RÉSEAU DE CAPTEURS SANS FIL

(30) Priorität: 23.10.2014 AT 507622014
(43) Veröffentlichungstag der Anmeldung: 30.08.2017
(73) Patentinhaber: AVL List GmbH, 8020 Graz (AT)
(72) Erfinder: PRILLER, Peter, A-8111 Gratwein-Straßengel (AT); ENTINGER, Alexander, A-4040 Linz (AT); BERGER, Achim, A-3340 Waidhofen/Ybbs (AT)
(74) Vertreter: Patentanwälte Pinter & Weiss OG
(86) Internationale Anmeldenummer: PCT/EP2015/074616
(87) Internationale Veröffentlichungsnummer: WO 2016/062865

(56) Entgegenhaltungen:
- EP-A1- 1 710 940
- WO-A1-02/07374
- WO-A1-2009/141106
- WO-A2-02/071736
- US-B2- 8 327 232
- UHLEMANN E ET AL: "Hard decision packet combining methods for industrial wireless relay networks", COMMUNICATIONS AND ELECTRONICS, 2008. ICCE 2008. SECOND INTERNATIONAL CONFERENCE ON, IEEE, PISCATAWAY, NJ, USA, 4. Juni 2008 (2008-06-04), Seiten 104-108, XP031291455, ISBN: 978-1-4244-2425-2 in der Anmeldung erwähnt

## Beschreibung

Die gegenständliche Erfindung betrifft ein Verfahren zur Rekonstruktion eines fehlerhaft empfangenen Datenpakets, das in einem drahtlosen Sensornetzwerk von einem Funkknoten in Form von Datenfeldern, die vorab bekannte Information enthalten an eine Empfangseinheit gesendet wurde.

Zum Steuern, Regeln, Überwachen von Maschinen, wie z.B. Produktionsmaschinen, Kraftfahrzeugen, Handhabungsmaschinen (Roboter), usw., oder Anlagen, wie z.B. Produktionsanlagen, Fertigungsanlagen, Prüfstände für Fahrzeuge oder Fahrzeugteile, usw., werden eine Vielzahl von Sensoren eingesetzt, die verschiedenste Messgrößen erfassen und die erfassten Messwerte der Messgrößen an zugeordnete Steuereinheiten senden. In gleichem Maße umfassen solche Maschinen und Anlagen auch eine Vielzahl von Aktuatoren, um darüber die Maschine oder Anlage unter Kontrolle der Steuereinheit zu steuern. Beispielsweise umfasst ein modernes Fahrzeug unterschiedliche Steuereinheiten, wie z.B. eine Motorsteuereinheit (ECU), eine Getriebesteuereinheit (TCU), eine Hybridsteuereinheit (HCU), eine Bremssteuereinheit (BCU), etc., die alle verschiedene Messwerte von verschiedenen am Fahrzeug verbauten Sensoren erhalten und verarbeiten. Basierend auf diesen Messwerten werden mit ebenfalls verbauten Aktuatoren unterschiedliche Eingriffe am Fahrzeug oder an Fahrzeugkomponenten vorgenommen, beispielsweise das Verstellen des Luft-Kraftstoffverhältnisses anhand einer aktuellen CO-, CO₂- oder NOx-Gehalts im Abgas. Die Gesamtheit der verbauten Sensoren und Aktuatoren, oder ein Teil davon, wird als Sensornetzwerk bezeichnet.

Die Vielzahl der Sensoren und Aktuatoren muss aber mit der / den Steuereinheit(en) verbunden werden, was eine Verdrahtung bedingt. Hierbei werden häufig Feldbusse eingesetzt, mit der I/O-Einheiten und eine Steuereinheit über einen Datenbus, z.B. CAN, LIN, FlexRay, Ethernet, etc., miteinander verbunden sind. Die Sensoren und Aktuatoren sind mit einer I/O-Einheit, die als Busteilnehmer am Datenbus angeschlossen ist, verdrahtet. Daneben gibt es auch noch festverdrahtete Systeme, in denen ein Sensor mit einer zugeordneten Steuereinheit über ein eigenes Kabel fest verdrahtet ist. Das bedingt einen enormen Verkabelungsaufwand mit hohen Kosten, hohem Fehlerpotential, hohem Installationsaufwand, hohem Wartungsaufwand und hohem Gewicht.

In Abkehr von solchen drahtgebundenen Sensornetzwerken werden zunehmend auch drahtlose Sensornetzwerke eingesetzt, in denen ein drahtloser Sensor /Aktuator, im weiteren Funkknoten bezeichnet, über eine drahtlose Datenverbindung Daten mit einer zugeordneten Steuereinheit austauscht. Damit entfällt der bisher hierfür notwendige Verdrahtungsaufwand zumindest teilweise. Solche drahtlose Sensornetzwerke umfassen eine Vielzahl von Funkknoten, die mit einer zugeordneten Basisstation kommunizieren. Hierbei können natürlich auch mehrere Basisstationen, mit denen jeweils mehrere Funkknoten verbunden sind, vorgesehen sein.

Aber auch in drahtlosen Sensornetzwerken ergeben sich eine Reihe von Problemen. Die industrielle Umgebung des drahtlosen Sensornetzwerkes ist häufig rau mit vielen Störmöglichkeiten (z.B. elektromagnetische Störquellen, Signalabschattungen, Signalreflexionen, etc.) für die drahtlose Datenkommunikation. Daneben muss sich das drahtlose Sensornetzwerk den Übertragungskanal (insbesondere einen bestimmten Frequenzbereich) häufig auch mit anderen drahtlosen Kommunikationssystemen, wie z.B. ein WLAN oder Bluetooth, teilen, was ebenfalls für Störungen sorgen kann. Nicht zuletzt ist auch die Energieversorgung der drahtlosen Sensoren / Aktuatoren ein großes Problem, da für den industriellen Einsatz eine ausreichende Standzeit der Funkknoten erforderlich ist. Insbesondere die drahtlose Datenübertragung benötigt aber große Mengen elektrischer Energie, sodass die Batterielebensdauer der Funkknoten problematisch sein kann. Darüber hinaus muss auch eine ausreichend niedrige Datenübertragungsfehlerrate und hohe Datenübertragungsrate in der Datenübertragung erzielbar sein, um ein drahtloses Sensornetzwerk im industriellen Umfeld überhaupt einsetzen zu können.

Grundsätzlich gibt es in der digitalen Datenübertragungstechnik bekannte Fehlererkennungs- und Fehlerkorrekturmechanismen, die auch bei drahtlosen Sensornetzwerken einsetzbar wären. Diese Mechanismen codieren vor der Übertragung vorhandene Informationen, die daraufhin in Form von Daten übertragen werden, womit die Informationen bei der Übertragung und beim Empfang nicht mehr direkt vorliegen, sondern erst am Empfänger decodiert werden müssen. Allerdings umfassen solche Fehlererkennungs- und Fehlerkorrekturmechanismen durchaus komplexe Berechnungen, die im Falle eines drahtlosen Sensornetzwerkes in den sendenden Funkknoten durchgeführt werden müssten, was aber energieaufwendig ist. Auch auf Empfängerseite erhöht das natürlich den Rechenaufwand, da die codierten Daten zuerst gemäß den Fehlererkennungs- und Fehlerkorrekturmechanismen decodiert werden müssen. Solche Methoden sind daher bei drahtlosen Sensornetzwerken im industriellen Umfeld kaum einsetzbar.

Drahtlose Sensornetzwerke waren daher in den letzten Jahren Gegenstand vieler Forschungs- und Entwicklungsarbeiten, um die damit verbundenen Probleme zu lösen.

Um die Datenübertragungsfehlerrate zu reduzieren, wurden bereits auf die Anforderungen in drahtlosen Sensornetzwerken abgestellte Strategien entwickelt, um empfangene Daten zu überprüfen und zu korrigieren. In E. Uhlemann, et al., "Hard decision packet combining methods for industrial wireless relay networks", Communications and Electronics, 2008. IC-CE 2008. Second International Conference on Communication and Electronics, 4.-6. Juni 2008, S.104-108 wird beispielsweise beschrieben, wie empfange Daten im Empfänger auf Basis eines CRC (Cyclic Redundancy Code) korrigiert werden. Dazu wird ein fehlerhaft empfangenes Datenpaket, was anhand des CRC festgestellt wird, nicht weggeworfen, sondern in einem Puffer gespeichert. Das fehlerhaft empfangene Datenpaket wird vom Sender nochmals übermittelt. Ergibt die Überprüfung des CRC erneut eine fehlerhafte Datenübertragung, werden die vorher gepufferte Nachricht und die neu empfangene Nachricht bitweise analysiert und versucht, daraus die korrekten Daten zu rekonstruieren, indem die Bits in den Positionen, in denen sich die beiden Datenpakete unterscheiden, durchiteriert werden und dabei jeweils der CRC geprüft wird. Dieses Verfahren ist als Combinatorial Testing bekannt. Falls das Datenpaket nicht rekonstruiert werden kann, kann eine weitere Neuübertragung des Datenpakets angefordert werden. Damit gelingt es die Datenübertragungsfehlerrate und die Anzahl der notwendigen Datenübertragungen zu reduzieren. Ein ähnliches Vorgehen kann auch aus der US 8,327,232 B2 entnommen werden.

Der Nachteil dieser Methode ist, dass hierfür immer eine Neuübertragung des fehlerhaft empfangenen Datenpakets notwendig ist, was aus Sicht der beschränkt vorhandenen elektrischen Energie im sendenden Funkknoten aber unerwünscht ist, da damit die Batterielebensdauer herabgesetzt wird.

Die WO 2009/141106 A1offenbart ein Verfahren, welches eine parallele Verarbeitung von empfangenen Datenpaketen zur Fehlerkorrektur verwendet. Dabei werden Datenpakete abwechselnd einer ersten Einheit und einer zweiten Einheit zugewiesen, welche die erhaltenen Datenpakete parallel auf Fehlerfreiheit prüfen und abwechselnd an eine Datensenke übergeben. Die WO 02/071736 A2 verwendet Verfahren zur Behandlung von Fehlern zu, wobei Datenpakete korrigiert oder nochmals gesendet werden.Es ist nun eine Aufgabe der gegenständlichen Erfindung, ein Verfahren zur Rekonstruktion eines fehlerhaft empfangenen Datenpakets in einer Empfangseinheit eines drahtlose Sensornetzwerkes anzugeben, das mit einer geringeren Anzahl von Neuübertragungen des Datenpakets auskommt.

Diese Aufgabe wird durch ein Verfahren gelöst, bei dem in der Empfangseinheit eine erste und eine zweite Methoden zur Rekonstruktion eines fehlerhaft empfangenen Datenpakets unter Verwendung der in den Datenfeldern enthaltenen vorab bekannten Information implementiert werden, in einem ersten Schritt die erste Methode zur Rekonstruktion des fehlerhaft empfangenen Datenpakets angewendet wird und dabei überprüft wird, ob damit das Datenpaket rekonstruiert wurde und in einem folgenden zweiten Schritt die zweite Methode zur Rekonstruktion des fehlerhaft empfangenen Datenpakets angewendet wird, falls das fehlerhaft empfangene Datenpaket mit der ersten Methode nicht rekonstruiert wurde, und dabei überprüft wird, ob damit das Datenpaket rekonstruiert wurde.

In einer Variante der Erfindung werden in der Empfangseinheit also eine erste und eine zweite Methode zur Rekonstruktion eines fehlerhaft empfangenen Datenpakets unter Verwendung des vorab bekannten Inhalts verschiedener Datenfelder und/oder über bestimmte Bits des Datenpakets ableitbarer Informationen implementiert. Dabei wird ausgenutzt, dass Datenfelder von versendeten Datenpaketen vorab bekannte Inhalte (Information) aufweisen. Auch aus den vorab bekannten Informationen abgeleitete Informationen gelten als bekannte Informationen.

Dadurch, dass verschiedene Methoden zur Rekonstruktion implementiert werden, können verschieden komplexe Methoden angewendet werden, die verschiedenen Berechnungsaufwand erfordern und verschiedene Erfolgswahrscheinlichkeiten versprechen. Das ermöglicht es, in einem ersten Schritt auf das fehlerhaft empfangene Datenpaket eine einfache erste Methode anzuwenden, die vorzugsweise mit wenig Berechnungsaufwand das Auslangen findet. Ist die erste Methode erfolgreich, kann das Datenpaket also erfolgreich rekonstruiert werden, erübrigt es sich, eine zweite Methode anzuwenden oder gar eine Neuübertragung des Datenpakets anzufordern. Mit der zweiten Methode kann am fehlerhaft empfangenen Datenpaket ein erneuter Versuch der Rekonstruktion unternommen werden, ebenfalls ohne dazu eine Neuübertragung des Datenpakets zu benötigen. Hierbei werden Methoden bevorzugt, die es ermöglichen, mit wenig Berechnungsaufwand auszukommen. Der Hintergedanke dafür ist, dass aufgrund des implementierten Datenübertragungsprotokolls nur eine eingeschränkte Zeitspanne verfügbar ist, bis bei einer Fehlübertragung eine Neuübertragung des Datenpakets angefordert werden muss. Somit steht nur diese beschränkte Zeitspanne zur Verfügung, um Rekonstruktionsversuche zu unternehmen. Sinnvollerweise beginnt man daher mit einer Methode, die weniger Berechnungsaufwand erfordert, da dann die Wahrscheinlichkeit groß ist, dass noch für die Durchführung einer zweiten Methode ausreichend Zeit bleibt. Die aufeinanderfolgende Anwendung verschiedener Methoden zur Rekonstruktion eines fehlerhaft empfangenen Datenpakets erhöht insgesamt die Wahrscheinlichkeit, dass ein fehlerhaft empfangenes Datenpakte rekonstruiert wird, ohne dass dafür eine Neuübertragung erforderlich wäre.

Die vom Funkknoten gesendeten Datenpakete bestehen aus Datenfeldern mit Daten, welche Information direkt (also uncodiert, ohne Codierung durch Fehlererkennungs- und Fehlerkorrekturmechanismen) enthalten. Das heißt, dass die Information ohne Anwendung gängiger Fehlererkennungs- und Fehlerkorrekturmechanismen direkt als Daten in den Datenfeldern enthalten sind. Das steht im Gegensatz zu im Rahmen einer Vorwärtsfehlerkorrektur mit bekannten Fehlererkennungs- und Fehlerkorrekturmechanismen codierten Informationen. Im letzteren Fall wären bei Übertragung und Empfang in den Datenfeldern lediglich Daten enthalten, die am Empfänger decodiert werden müssen, um die Informationen zu erhalten. Hierbei wird auch vermieden, in der Empfangseinheit eine sehr leistungsstarke Hardware, z.B. großer RAM, schneller Prozessor, hochgradig paralleler Rechner (Mulit-Core), etc., verwenden zu müssen. Das wäre ansonsten zur Decodierung der Informationen erforderlich. Das würde natürlich die Anwendung sehr komplexer Methoden zur Rekonstruktion ermöglichen, allerdings könnte dafür keine verfügbare Standard Hardware als Empfangseinheit verwendet werden. Im Gegensatz dazu ermöglicht die Erfindung möglichst hohe Reparaturerfolge bei möglichst geringem Hardwareaufwand.

Damit kann eine Rekonstruktion fehlerhaft empfangener Datenpakete ohne Neuübertragung, zumindest mit wenigen Neuübertragungen, gelingen, ohne auf bisher üblichen, aufwendigen Fehlererkennungs- und Fehlerkorrekturmechanismen angewiesen zu sein.

Das Verfahren kann vorteilhafter Weise erweitert werden, indem in zumindest einem weiteren folgenden Schritt eine weitere, in der Empfangseinheit implementierte Methode zur Rekonstruktion des fehlerhaft empfangenen Datenpakets angewendet wird, falls das fehlerhaft empfangene Datenpaket mit der zweiten Methode nicht rekonstruiert wurde, und dabei überprüft wird, ob damit das Datenpaket rekonstruiert wurde. Die Anwendung weitere Rekonstruktionsmethoden erhöht die Wahrscheinlichkeit, dass ein fehlerhaft empfangenes Datenpaket rekonstruiert wird, ohne dass dafür eine Neuübertragung erforderlich wäre, weiter.

Eine besonders einfache, mit geringem Berechnungsaufwand durchführbare erste Methode ergibt sich, wenn der Wert zumindest eines Bits eines Datenfeldes des Datenpakets bekannt ist und im fehlerhaft empfangenen Datenpaket dieses zumindest eine Bit geändert wird und dabei überprüft wird, ob mit dieser Änderung das Datenpaket rekonstruiert wurde. Hierbei kann A-Priori bekanntes Wissen über die Struktur des Datenpakets genutzt werden, um schnell bestimmte Bits des Datenpakets auf einen allfälligen Fehler zu untersuchen.

Bei einer vorteilhaften zweiten Methode wird A-Posteriori ableitbares Wissen über das Datenpaket verwendet, wobei aus dem fehlerhaft empfangenen Datenpaket der erwartete Wert zumindest eines Bits eines Datenfeldes abgeleitet wird und dieses zumindest eine Bit im fehlerhaft empfangenen Datenpaket geändert wird und dabei überprüft wird, ob mit dieser Änderung das Datenpaket rekonstruiert wurde. Bei dieser Methode wird also aus der in den Daten enthaltenen bekannten Information andere Information abgeleitet, die damit auch bekannte Information ist.

Hier ist der Berechnungsaufwand etwas höher als bei der ersten Methode, da das Datenpaket zuerst untersucht werden muss, kann aber auch auf Standard Hardware immer noch schnell genug ausgeführt werden.

Um die Reparaturwahrscheinlichkeit noch weiter zu erhöhen, kann eine weitere Methode zur Rekonstruktion eines fehlerhaft empfangenen Datenpakets implementiert werden, die gegebenenfalls nach der zweiten Methode ausgeführt wird, falls die vorhergehenden beiden Methoden erfolglos geblieben sind. Hierbei ist eine vorteilhafte weitere Methode, wenn ein Fehlerblock mit einer Länge von Bits schrittweise über zumindest einen Teil des fehlerhaft empfangenen Datenpakets geschoben wird und in jedem Schritt alle im Fehlerblock liegenden Bits invertiert werden und in jedem Schritt überprüft wird, ob mit dieser Änderung das Datenpaket rekonstruiert wurde. In einer möglichen Adaption der weiteren Methode können in jedem Schritt die im Fehlerblock liegenden Bits durchiteriert und dabei jeweils überprüft werden, ob mit dieser Änderung das Datenpaket rekonstruiert wurde, was die Wahrscheinlichkeit der Rekonstruktion weitere erhöht.

Falls es nicht gelingen sollte, das Datenpaket ohne Neuübertragung zu rekonstruieren, kann vorgesehen sein, weitere Methoden anzuwenden, die auf der Neuübertragung des Datenpakets basieren. Eine mögliche Methode besteht darin, zumindest zwei fehlerhaft empfangene Datenpakete miteinander zu vergleichen und Bitpositionen zu ermitteln, an denen sich die beiden Datenpakete unterscheiden und die Bits an zumindest einer dieser Bitpositionen schrittweise durchzuiterieren und dabei in jedem Schritt zu überprüfen, ob mit dieser Änderung das Datenpaket rekonstruiert wurde. Dabei kann auch vorgesehen sein, um die Bitposition einen Bitbereich mit einer Anzahl von Bits vor und/oder eine Anzahl von Bits nach der Bitposition zu definieren und die Bits im Bitbereich schrittweise durchzuiterieren.

Die gegenständliche Erfindung wird nachfolgend unter Bezugnahme auf die Figuren 1 bis 11 näher erläutert, die beispielhaft, schematisch und nicht einschränkend vorteilhafte Ausgestaltungen der Erfindung zeigen. Dabei zeigt
Fig.1 eine typische Konfiguration eines drahtlosen Sensornetzwerkes,
Fig.2 die die Datenübertragung nach einem synchronen Zeitmultiplexverfahren,
Fig.3 ein Schema zur Neuübertragung eines Datenpakets,
Fig.4 den Aufbau eines Datenpakets mit verschiedenen Datenfeldern,
Fig.5 und 6 Beispiele von a-priori vorhandenem Wissen über den Inhalt bestimmter Datenfelder,
Fig.7 und 8 ein Beispiel einer Methode zur Rekonstruktion eines fehlerhaft empfangenen Datenpakets,
Fig.9 und 10 ein Beispiel einer Methode zur Rekonstruktion eines fehlerhaft empfangenen Datenpakets, das eine Neuübertragung des Datenpakets erfordert und
Fig.11 einen möglichen Verfahrensablauf beim erfindungsgemäßen Verfahren zur Rekonstruktion eines fehlerhaft empfangenen Datenpakets.

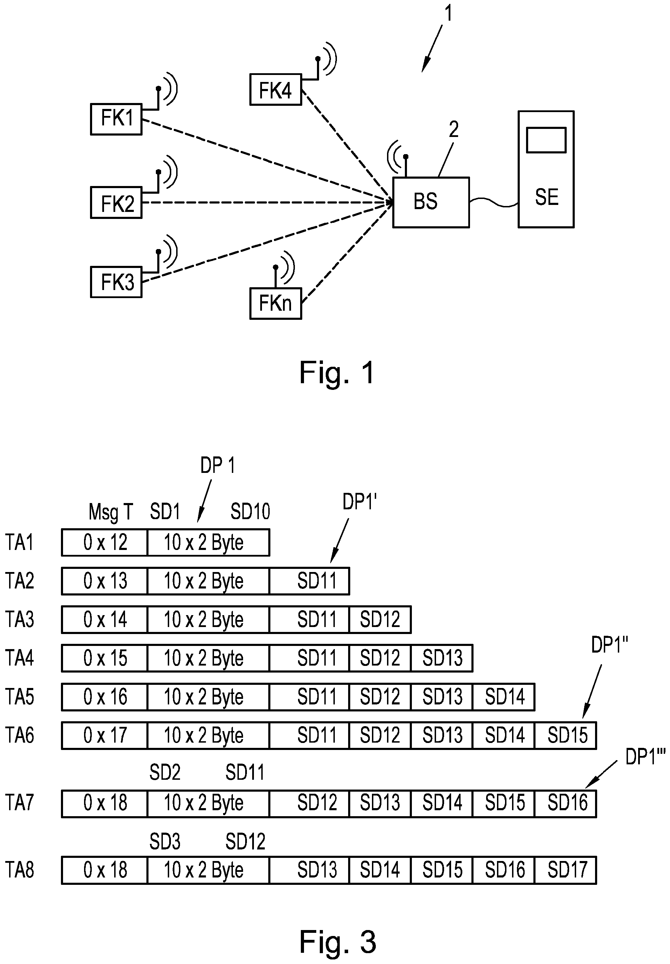

In Fig.1 ist eine typische Konfiguration in einem drahtlosen Sensornetzwerk 1 mit einer Basisstation BS dargestellt. Eine Anzahl von Funkknoten FK1 ... FKn sind drahtlos mit der zugeordneten Basisstation BS verbunden (durch strichlierte Linien angedeutet) und tauschen mit dieser über eine drahtlose Datenverbindung Daten aus. Die Basisstation BS ist wiederum mit einer Steuereinheit SE verbunden, an der auch mehrere Basisstationen BS, jeweils mit einer Anzahl zugeordneter Funkknoten FK, angeschlossen sein können. Die Basisstation BS und die Steuereinheit SE könnten natürlich auch in einem Gerät integriert sein. Im Falle eines Sensors als Funkknoten FK sendet der Funkknoten FK Daten (in der Regel Messwerte einer Messgröße) in Form von Datenpakten DP an die Basisstation BS, im Falle eines Aktuators als Funkknoten FK entsprechend umgekehrt, wobei die Daten hierbei typischerweise Steueranweisungen umfassen. Die Basisstation BS kann auch zur Implementierung eines Datenübertragungsprotokolls Datenpakete DP an einen oder alle Funknoten FK übertragen, z.B. um eine Neuübertragung eines bestimmten Datenpakets DP anzufordern, beispielsweise wenn dieses Datenpaket fehlerhaft empfangen wurde. Allerdings ist anzumerken, dass es für die gegenständliche Erfindung nicht auf das konkrete Datenübertragungsprotokoll ankommt, das daher nur soweit beschrieben ist, als es für das Verständnis der Erfindung von Nöten ist.

Es ist zu beachten, dass das Datenpaket DP Informationen in verschiedenen Datenfeldern DF beinhaltet. Die Datenfelder DF enthalten direkt (also uncodiert) Informationen. Diese Informationen werden in Form von Daten in Datenfeldern DF vom Funkknoten FK zur Empfangseinheit 2 übertragen. Zuvor codierte Informationen würden beispielsweise bei gängigen Fehlererkennungs- und Fehlerkorrekturmechanismen übertragen, die erfindungsgemäß nicht angewendet werden sollen.

Je nach Topologie des drahtlosen Sensornetzwerkes 1 kann anstelle einer Basisstation BS auch ein anderer Netzwerkteilnehmer vorgesehen sein, z.B. ein Repeater (auch ein als solcher funktionierender Funkknoten), der drahtlose mit einer Anzahl von Funkknoten FK verbunden ist. Daher wird im Folgenden allgemein von einer Empfangseinheit 2 gesprochen.

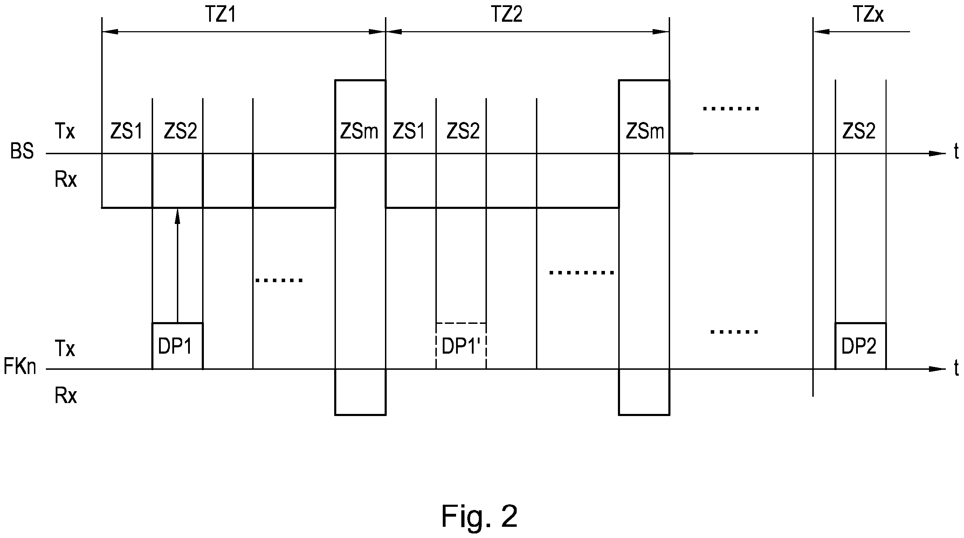

Für ein drahtloses Sensornetzwerk 1 ist es vorteilhaft, wenn die Datenübertragung nach einem synchronen Zeitmultiplexverfahren (synchroneous Time Division Multiple Access, TDMA) implementiert ist, wobei die Erfindung allerdings nicht darauf beschränkt ist. Beim TDMA-Verfahren werden in einem zyklisch wiederholten Übertragungszyklus TZ m Zeitschlitze ZSm definiert, innerhalb denen jeweils ein zugewiesener Funkknoten FKn senden darf. Jeder Funknoten FKn sendet daher in einem Übertragungszyklus TZ immer im gleichen Zeitschlitz ZS. Um die benötigte Energie für die Datenübertragung nieder zu halten, kann vorgesehen sein, dass nicht in jedem Übertragungszyklus TZ Daten übertragen werden, sondern die Daten im Funkknoten FKn gesammelt werden und die gesammelten Daten in einem Datenpaket DP nur in jedem x-ten Übertragungszyklus TZ übertragen werden. Das ist schematisch in Fig.2 dargestellt. Im Übertragungszyklus TZ1 sendet der Funknoten FKn im zugeordneten Zeitschlitz ZS2 ein Datenpaket DP1 an die Empfangseinheit 2. Nach x Übertragungszyklen TZx sendet der Funknoten FKn erneut ein Datenpaket DP2. Die Empfangseinheit 2 sendet in jedem Übertragungszyklus TZ eine Rückantwort an die Funknoten FK, hier jeweils im letzten Zeitschlitz ZSm, beispielsweise mit einer Bestätigung des Erhalts eines Datenpakets DP1 und/oder der Anforderung der Neuübertragung bestimmter Datenpakete DP. Im Falle einer Neuübertragung würde der Funkknoten FKn nicht bis zum nächsten Übertragungszyklus TZx warten, sondern bereits im nächstfolgenden Übertragungszyklus TZ2 das Datenpaket DP1' erneut senden.

In einer beispielhaften Ausgestaltung kann die Länge des Übertragungszyklus TZ 100ms betragen, der auf m=10 Zeitschlitze ZSm mit einer Länge von 10ms aufgeteilt ist. Damit könnten an einer Empfangseinheit neun Funkknoten FKn (ein Zeitschlitz ZSm für den Rückkanal) angeschlossen werden. Ein Funknoten FKn sendet jeden x=10ten Übertragungszyklus TZ. Erfasst der Funkknoten FKn als Sensor alle 100ms Sensordaten (beispielsweise einen Messwert), so kann der Funkknoten jede Sekunde zehn Sensordaten SD in einem Datenpaket DP an die Empfangseinheit 2 senden.

In Fig.3 ist beispielhaft ein Schema zur Neuübertragung eines Datenpakets DP dargestellt. Bei der ersten Übertragung TA1 wird ein Datenpaket DP1 mit z.B. zehn Sensordaten SD1...SD10 zu einer Länge von jeweils 2 Byte übertragen. Bei einer Neuübertragung TA2 werden die Sensordaten SD1...SD10 im Datenpaket DP1' im nächsten Übertragungszyklus TZ erneut gesendet, wobei ein zwischenzeitlich neuer erfasster Messwert als zusätzliche Sensordaten SD11 angefügt wird. Das kann bis zu einer bestimmten maximalen Länge des Datenpakets DP1 wiederholt werden. Im dargestellten Beispiel werden fünf Neuübertragungen mit jeweils neuen Sensordaten SD11...SD15 zugelassen (Datenpaket DP1"). Danach würden die jeweils ältesten Sensordaten entfernt werden, beispielsweise die Sensordaten SD1 aus einem neuen Datenpaket DP1"', wodurch es zu einem Datenverlust kommen würde. Um die Neuübertragungen TA2...TA8 unterscheiden zu können, können im Datenpaket DP auch unterschiedliche Nachrichtentypen MsgT definiert sein.

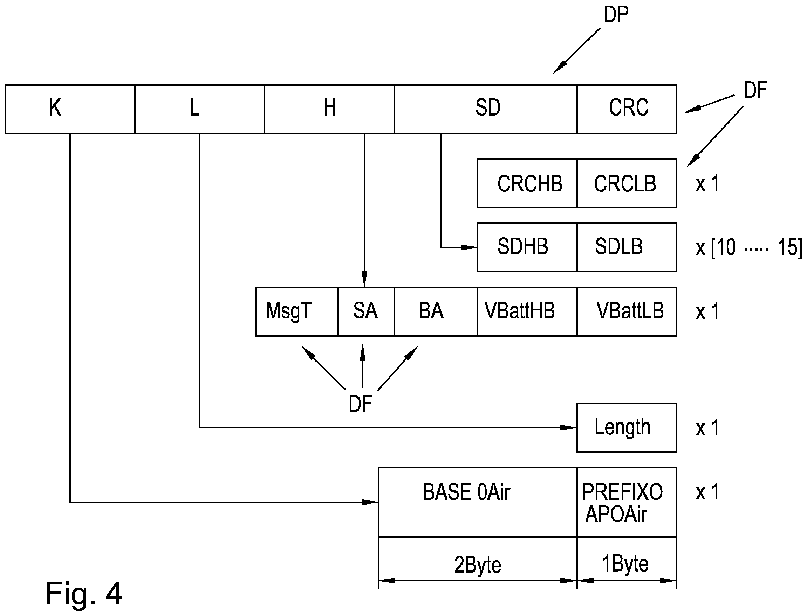

Der Aufbau eines Datenpakets DP für die Umsetzung der Erfindung ist beispielhaft in Fig.4 dargestellt. Das Datenpaket DP enthält verschiedene Datenfelder DF, beispielsweise 3 Byte zur Kennzeichnung des logischen Kanals K, der im Wesentlichen die zugeordnete Empfangseinheit definiert, 1 Byte mit einer Länge L des Datenpakets DP, 5 Byte mit Headerdaten H, 10-15 mal 2 Byte mit Sensordaten SD und 2 Byte mit einem Prüfwert CRC.

Die Headerdaten H umfassen wiederum verschiedene Datenfelder DF, hier einen Nachrichtentyp MsgT, eine Funkknotenadresse SA im drahtlosen Sensornetzwerk, eine Base Address als eindeutige Adresse einer Empfangseinheit 2 und 2 Byte den aktuellen Ladezustand VBatt der Versorgungsbatterie des Funkknotens FK. Die 2 Byte Sensordaten SD werden jeweils in einem High Byte SDHB und einem Low Byte SDLB übertragen. Gleichfalls ist der Prüfwert CRC in ein High Byte CRCHB und ein Low Byte CRCLB aufgeteilt, genauso wie der Ladezustand VBatt. Diese Datenstruktur eines Datenpakets DP ist natürlich nur beispielhaft und kann beliebig gewählt werden.

Das erfindungsgemäße Verfahren nutzt nun den Umstand aus, dass der Inhalt bestimmter Datenfelder DF vorab bekannt ist, z.B. aufgrund des implementierten Datenprotokolls oder aufgrund der Kenntnis der übertragenen Daten. Die Information in den Daten dieser bestimmten Datenfeldern DF ist damit bekannt, wobei die in den Daten enthaltene Information in der Empfangseinheit 2 unmittelbar ausgewertet werden kann, da die Daten vom Funknoten FK uncodiert übertragen werden. Dadurch können bestimmte Bitwerte von Datenfeldern DF erwartet werden, wie nachfolgend anhand von Beispielen dargelegt wird.

### Datenfeld Länge L:

Als Länge L kann je nach Datenübertragungsprotokoll die Länge bestimmter Datenfelder DF im Datenpaket DP oder auch die Gesamtlänge des Datenpakets DP angegeben werden. Wenn z.B. die Gesamtlänge eines Datenpakets DP nach Fig.4 zwischen 31 Byte und 41 Byte liegt (je nach Länge der Sensordaten SD) und Overheaddaten, wie z.B. der logische Kanal K, die Länge L und der Prüfwert CRC abgezogen werden, dann könnte das Datenfeld DF für die Länge L die Länge der Nutzdaten angeben, die hier den Nachrichtentyp MsgT, die Funkknotenadresse SA, die Base Adress BA und den aktuellen Ladezustand VBatt, umfassen. Damit kann das Datenfeld DF für die Länge L nur die Werte im Bereich von 25 bis 35 annehmen, also L = [25, 35], oder binär ausgedrückt L = [0001 1001, 0010 0011], wobei der Wert nur um 2 steigen kann, da die Sensordaten SD jeweils 2 Bytes umfassen. Damit müssen die zwei höchsten Bits des Datenfeldes DF für die Länge L immer 0 sein und das niedrigste Bit immer 1.

### Base Address BA:

Die Base Address BA der Empfangseinheiten 2 im drahtlosen Sensornetzwerk 1 werden vorab vergeben und sind damit bekannt. Sind z.B. drei Empfangseinheiten 2 mit Base Address BA (hexadezimal) 0x01, 0x02, 0x03 vorhanden, dann müssen die fünf höchsten Bits des Datenfeldes DF für die Base Address BA immer 0 sein.

### Nachrichtentyp MsgT:

Die möglichen Nachrichtentypen werden durch das implementierte Datenübertragungsprotokoll festgelegt. Im Beispiel nach Fig.3 sind z.B. nur die folgenden Werte möglich (Hexadezimal): MsgT = (0x12, 0x13, ..., 0x18). Damit ergibt sich, dass die höchsten vier Bits des Datenfeldes DF für den Nachrichtentyp MsgT immer 0 sein müssen.

### Ladezustand VBatt:

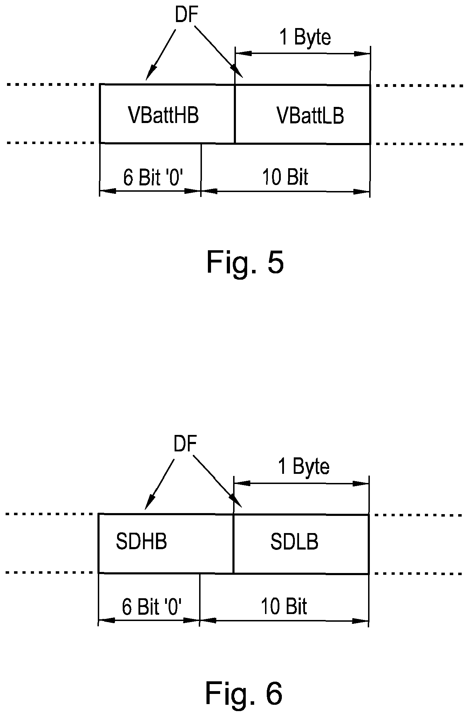

Aus der Kenntnis der eingesetzten Funkknotens FKn, ist bekannt, mit welcher Auflösung der Ladezustand VBatt übermittelt wird. Wird z.B. im Funkknoten als Ladezustand VBatt die Batteriespannung gemessen und mit einem 10 Bit Analog-Digital-Wandler (ADC) digitalisiert, dann kann das Datenfeld DF für den Ladezustand VBatt nur die niedrigsten zehn Bits belegen, womit die höchsten sechs Bits immer 0 sein müssen, wie in Fig.5 dargestellt.

### Sensordaten SD:

Aus der Kenntnis der eingesetzten Funkknotens FKn, ist bekannt, mit welcher Auflösung Messwerte erfasst werden. Wird z.B. im Funkknoten ein Messwert gemessen und mit einem 10 Bit ADC digitalisiert, dann kann ein Datenfeld DF für Sensordaten SD nur die niedrigsten zehn Bits belegen, womit die höchsten sechs Bits immer 0 sein müssen, wie in Fig.6 dargestellt.

In einem drahtlosen Sensornetzwerk 1 werden damit von einem Funkknoten FK Datenpakete DP an eine Empfangseinheit 2 gesendet, wobei das Datenpaket DP mehrere Datenfelder DF beinhaltet und zumindest von einem Datenfeld DF der Wert zumindest eines Bits des Datenfeldes DF vorab bekannt ist. Wird in der Empfangseinheit 2 ein Datenpaket DP empfangen und festgestellt, beispielsweis anhand des enthaltenen Prüfwertes CRC, dass das Datenfeld korrumpiert ist, kann diese Information für einen Versuch der Rekonstruktion des Datenpaktes DP genutzt werden, ohne dafür eine Neuübertragung des Datenpakets DP zu benötigen. In der Empfangseinheit 2 kann dazu ein Datenfeld DF des Datenpakets DP mit einem erwarteten bekannten Bitwert untersucht werden und überprüft werden, ob an der erwartenden Bitposition der erwartete Wert (0 oder 1) enthalten ist. Ist das nicht der Fall, kann der Wert dieses Bits geändert werden und anhand des Prüfwertes CRC überprüft werden, ob damit das empfangene Datenpaket DP rekonstruiert werden konnte. Das kann für alle Bits des Datenpakets DP, die einen bestimmten bekannten Wert aufweisen müssen, wiederholt werden. Mit dieser Vorgehensweise gelingt es häufig Datenpakete DP zu rekonstruieren, ohne dafür eine Neuübertragung des Datenpakets DP zu benötigen. Dieses Verfahren wird in weitere Folge auch als A-Priori-Verfahren bezeichnet, weil vorab bekanntes Wissen eingesetzt wird.

Daneben können auch aus dem Datenpaket DP selbst Informationen abgleitet werden, die zur Rekonstruktion genutzt werden könnten. Auch die ableitbare Information über bestimmte Bits des Datenpakets DP wird als bekannte Information angesehen. Dabei wird also aus der in den Daten enthaltenen bekannten Information andere Information abgeleitet, die damit auch bekannte Information ist, wobei die in den Daten enthaltene Information in der Empfangseinheit 2 unmittelbar ausgewertet werden kann, da die Daten vom Funknoten FK uncodiert übertragen werden. Auch das läuft daraus hinaus, dass für bestimmte Datenfelder DF ein bestimmter Inhalt, also bestimmte Bitwerte, erwartet wird, wie nachfolgend anhand von Beispielen dargelegt wird.

### Nachrichtentyp MsqT:

Aus der Anzahl der im Datenpaket DP enthaltenen Sensordaten SD kann der Nachrichtentyp MsgT abgeleitet werden. Wie in Fig.3 dargestellt, erhält jede Neuübertragung eines Datenpakets DP einen eigenen Nachrichtentyp MsgT. Da mit jeder Neuübertragung gleichzeitig auch die Länge der Sensordaten SD (in 2 Byte Schritten) steigt, kann aus der Anzahl der Sensordaten SD ein erwarteter Nachrichtentyp MsgT abgeleitet werden. Werden z.B. 11 mal 2 Byte Sensordaten SD empfangen, dann wird ein Nachrichtentyp MsgT 0x13 erwartet (Fig.3).

### Sensor Address SA:

Bei Verwendung des TDMA Übertragungsverfahrens (siehe Fig.2) kann aus dem Zeitschlitz ZS in dem das Datenpaket DP empfangen wurde eine erwartete Sensor Address AS abgeleitet werden, da jeder Funkknoten FK (mit einer vergebenen Sensor Address SA) einem Zeitschlitz ZS zugeordnet ist. Ist der Funkknoten FK1 mit der Sensor Address SA 0x01 dem Zeitschlitz ZS1 zugeordnet, dann wird angenommen, dass jedes Datenpaket DP, das in diesem Zeitschlitz ZS1 empfangen wird von diesem Funkknoten FK1 stammt und dass daher die in diesen Datenpaketen DP enthaltene Sensor Address SA 0x01 sein muss.

Es kann daher wieder so vorgegangen werden, dass bei einem korrumpiert empfangenen Datenpaket DP der Wert zumindest eines Datenfeldes DF des Datenpakets DP anhand von vorab vorhandenem Wissen geändert wird und geprüft wird, ob eine solche Änderung das Datenpaket DP rekonstruiert. Dieses Verfahren wird in weitere Folge auch als A-Posteriori-Verfahren bezeichnet, weil Wissen aus einem empfangenen Datenpaket DP abgeleitet wird.

Abgesehen von der Anwendung von bekanntem oder ableitbarem Wissen über das Datenpaket DP können auch noch andere Mechanismen für einen Versuch der Rekonstruktion eines fehlerhaft empfangenen Datenpakets DP genutzt werden.

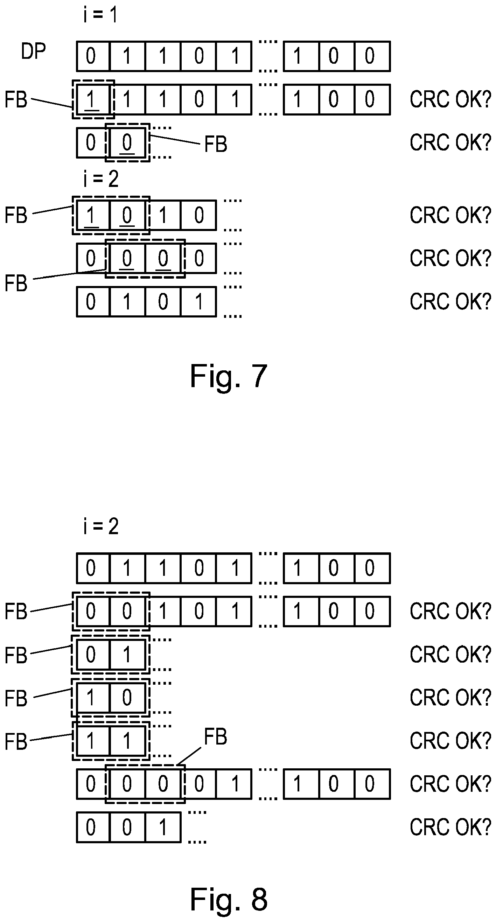

In einem ersten solchen Verfahren (auch als Consecutive Bits Verfahren bezeichnet), das mit Bezugnahme auf die Fig.7 beschrieben wird, wird ein Fehlerblock FB mit einer Länge von i Bits festgelegt. Der Fehlerblock FB wird über das gesamte Datenpaket DP oder über einen Teil des Datenpakets DP (beispielsweise Header H + Sensordaten SD) mit einer Schrittweite von 1 Bit geschoben und dabei jedes Bit im Fehlerblock FB invertiert und in jedem Schritt der Prüfwert CRC geprüft. Hierbei kann die Länge i auch in mehreren Durchläufen erhöht werden. Dieses Verfahren geht davon aus, dass burstartige Störungen auftreten und dass dabei immer mehrere benachbarte Bits gestört werden.

Im Beispiel nach Fig.7 wird über ein Datenpaket DP zuerst ein Fehlerblock FB mit einer Länge i=1 geschoben und dabei das jeweilige Bit im Fehlerblock FB gegenüber dem entsprechenden Bit im empfangenen Datenpaket DP invertiert (0 -> 1, 1 -> 0) (unterstrichene Bits). In jedem Schritt wird der Prüfwert CRC geprüft und abgebrochen, falls sich ein richtiger Prüfwert CRC ergibt. Falls nicht, wird die Länge i des Fehlerblocks FB um 1 erhöht, der Fehlerblock FB wieder über das Datenpaket DP geschoben und wieder alle Bits im Fehlerblock FB invertiert (unterstrichene Bits). Das kann bis zu einer bestimmten vorgegebenen Länge i wiederholt werden.

Mit Fig.8 ist noch eine Erweiterung zum Verfahren nach Fig.7 dargestellt. Dabei werden die Bits in einem Fehlerblock FB nicht einfach invertiert, sondern die Bits werden im Fehlerblock durchiteriert, sodass alle möglichen Bitbelegungen geprüft werden.

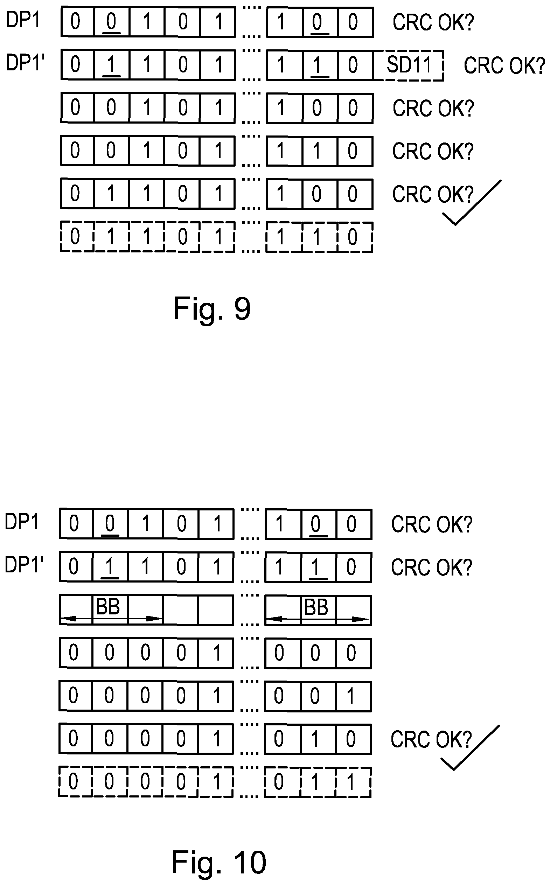

Auch damit kann ein Versuch eine Datenrekonstruktion durchgeführt werden, ohne eine Neuübertragung eines Datenpakets DP zu benötigen. Falls mit diesen Methoden ein fehlerhaftes Datenpaket DP nicht wiederhergestellt werden kann, dann können andere bekannte Verfahren, wie z.B. das Combinatorial Testing, wie nachfolgend mit Bezugnahme auf die Fig.9 beschrieben, angewendet werden.

Im Beispiel nach Fig.9 wurde ein Datenpaket DP1 empfangen und über den Prüfwert CRC festgestellt, dass das empfangene Datenpaket DP1 fehlerhaft ist. Das Datenpaket DP1 wird daraufhin gespeichert und eine Neuübertragung des Datenpakets DP1 angefordert. Das neu übertragene Datenpaket DP1' wird erneut anhand des Prüfwertes CRC geprüft. Ist das Datenpaket DP1' in Ordnung, wird es übernommen und es sind keine Rekonstruktionsversuche notwendig. Ist jedoch auch das neu übertragene Datenpaket DP1' fehlerhaft, kommt das Combinatorial Testing zur Anwendung. Hierbei ist aber zu berücksichtigen, dass das neu übertragene Datenpaket DP1' unter Umständen zusätzliche Sensordaten SD11 (vergleiche Fig.3) enthalten kann (wie in Fig. 9 angedeutet), die für das Combinatorial Testing sinnvoller Weise ausgeklammert werden sollten. Beim Combinatorial Testing werden zuerst die Bitpositionen ermittelt, an denen sich die Datenpakete DP1, DP1' unterscheiden (unterstrichen in Fig.9). Diese Bitpositionen werden nun durchiteriert, indem alle möglichen Bitwertbelegungen versucht werden und dabei jeweils der Prüfwert CRC berechnet wird. Stimmt der Prüfwert CRC wird das geänderte Datenpaket DP1 als korrektes Datenpaket weitergereicht. Falls damit keine erfolgreiche Rekonstruktion des Datenpakets DP1 gelingt, wird auch das zweite Datenpaket DP1' gespeichert und es kann eine erneute Neuübertragung angefordert werden. Das Combinatorial Testing kann dann bei Eingehen des erneut übertragenen Datenpakets DP1" auf alle gespeicherte Datenpakete DP1, DP1', DP1" angewendet werden oder auf eine beliebige Paarung der gespeicherten Datenpakete DP1, DP1', DP1".

In Fig.10 ist noch eine mögliche Adaption des Combinatorial Testing nach Fig.9 dargestellt. Hier werden i Bits vor und nach der sich unterscheidenden Bitpositionen (unterstrichen) hinzugenommen (in Fig.10 ist i=1) und alle möglichen Bitbelegungen in diesen Bitbereichen BB durchiteriert. Hierbei sind natürlich verschiedene Abwandlungen denkbar, wie beispielsweise die Ausweitung nur vor oder nur nach den sich unterscheidenden Bitpositionen oder unterschiedliche Anzahl von Bits vor und nach den sich unterscheidenden Bitpositionen.

In einer weiteren Adaption des Combinatorial Testing könnte man auch vorsehen, nicht sofort alle sich unterscheidenden Bitpositionen zu ändern, sondern nach gewissen Kriterien bestimmte Bitpositionen auszuwählen und diese zuerst zu ändern. Beispielsweise könnte das Datenfeld DF für den Ladezustand VBatt herangezogen werden, um bei niedrigem Ladezustand VBatt das Ende des Datenpakets DP zuerst untersucht werden, da bei niedrigem Ladezustand VBatt angenommen werden kann, dass aufgrund eines annähernd leeren Energiespeichers die Sendeleistung des Funkknotens FK einbricht. Auch wäre es denkbar, dass vorhergehende Rekonstruktionsversuche als Kriterium herangezogen werden und zuerst die Bits untersucht werden, an denen schon in früheren Rekonstruktionen Fehler erkannt wurden.

Zur Ermittlung des Prüfwertes CRC kann natürlich jede bekannte Methode (z.B. Cyclic Redundancy Check) verwendet werden, wobei es für die Verwendung in einem drahtlosen Sensornetzwerk natürlich vorteilhaft ist, wenn der Berechnungsaufwand für den Prüfwert CRC gering ist. Das Schema ist dabei aber immer das gleiche. Es wird aus bestimmten Datenfeldern DF des Datenpakets DP ein Prüfwert CRC berechnet und an das Datenpaket angehängt. Der Empfänger berechnet dann nach derselben Methode aus denselben Datenfeldern des empfangenen Datenpakets DP ebenfalls den Prüfwert CRC und vergleicht den berechneten mit dem übertragenen Prüfwert CRC. Bei Gleichheit wird von der Korrektheit der übertragenen Daten ausgegangen und bei Ungleichheit davon, dass die Daten fehlerhaft übertragen wurde.

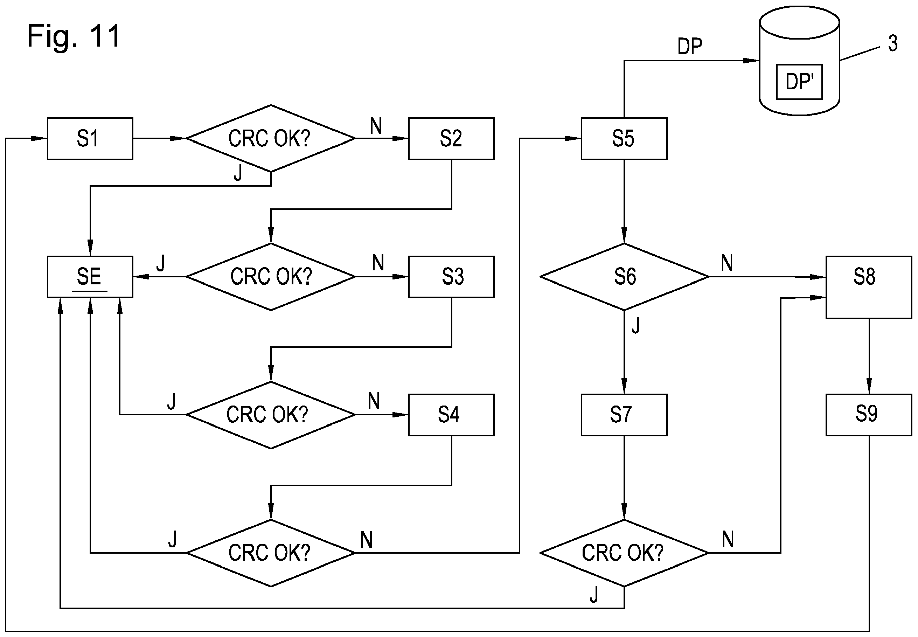

Ein Verfahren zur Rekonstruktion eines fehlerhaft empfangenen Datenpakets in einem drahtlosen Sensornetzwerk 1 kann damit wie beispielhaft anhand der Fig.11 beschrieben ablaufen. Um den speziellen Anforderungen in einem drahtlosen Sensornetzwerk 1 bestmöglich zu genügen, wird eine geeignete aufeinander folgende Sequenz von Methoden zur Rekonstruktion angewendet. Nachdem eine Neuübertragung im nächsten Übertragungszyklus TZ angefordert werden muss, muss nach fehlerhaftem Empfang eines Datenpakets DP die Rekonstruktion des Datenpakets DP innerhalb einer vorgegebenen Zeitspanne gelingen, oder es wird die Neuübertragung angefordert. Sinnvollerweise beginnt man mit der Methode, die die höchste Erfolgswahrscheinlichkeit bei möglichst geringem Berechnungsaufwand verspricht. Danach kommt die Methode mit der nächstbesten Erfolgswahrscheinlichkeit und/oder nächstbesten Berechnungsaufwand. Unter Erfolgswahrscheinlichkeit wird die Wahrscheinlichkeit verstanden, dass die Methode zur Rekonstruktion innerhalb der verfügbaren Zeit ausgeführt werden kann.

Im Schritt S1 wird ein von einem Funkknoten FKn gesendetes Datenpaket DP in einer Empfangseinheit 2 empfangen und der Prüfwert CRC geprüft. Stimmt der Prüfwert CRC, wird das Datenpaket DP (oder ein Teil davon) an eine übergeordnete Applikationsebene weitergereicht, hier z.B. an die Steuereinheit SE. Falls der Prüfwert CRC mit dem Inhalt des Datenpakets DP nicht übereinstimmt, kommt im Schritt S2 die erste Methode (A-Priori-Verfahren) zur Rekonstruktion des Datenpakets DP zur Anwendung, bei der der vorab bekannte Inhalt von Datenfeldern DF überprüft wird. Mit dieser Methode lassen sich mit geringem Berechnungsaufwand zielgenau bestimmte Bits des Datenpakets DP überprüfen und bietet damit eine hohe Erfolgswahrscheinlichkeit. Führt das nicht zur Rekonstruktion des Datenpakets DP, kann im Schritt S3, sofern noch ausreichend Zeit verbleibt, die zweite Methode (A-Posteriori-Verfahren) angewendet werden, bei der Information über Datenfelder DF direkt aus dem Inhalt des Datenpakets DP abgeleitet wird. Diese Methode benötigt etwas mehr Berechnungsaufwand, da dazu zuerst bestimmte Datenfelder DF ausgewertet werden müssen. Nachdem das A-Priori-Verfahren und das A-Posteriori-Verfahren ähnlich sind, könnten diese auch in einem Schritt ausgeführt werden. Führt auch das nicht zum Erfolg, kann im Schritt S4, sofern noch ausreichend Zeit verbleibt, die dritte Methode (Consecutive Bits) angewendet werden. Nachdem hier viele Bitkombinationen zu prüfen sind und jeweils der Prüfwert CRC zu berechnen ist, benötigt diese Methode entsprechend viel Berechnungsaufwand. Falls auch das nicht erfolgreich ist und falls noch ausreichend Zeit verbleibt, wird das empfangene Datenpaket DP im Schritt S5 in einem Datenpaketpuffer 3 abgelegt. Sind bereits vorher vom Funkknoten FKn fehlerhaft empfangene Datenpakete DP' im Datenpaketpuffer 3 enthalten (Abfrage S6), kann im Schritt S7 ein bekanntes Combinatorial Testing Verfahren angewendet werden. Sind noch keine vorher empfangenen Datenpakete DP' im Datenpaketpuffer 3 enthalten oder führt auch das Combinatorial Testing Verfahren nicht zum Erfolg, wird im Schritt S8 eine Neuübertragung des Datenpakets DP angestoßen. Im Schritt S9 wird auf das neu übertragene Datenpaket DP gewartet, womit sich nach Erhalt dieses Datenpakets DP das Vorgehen wiederholt.

Hier sind natürlich verschiedene Abwandlungen denkbar. Beispielsweise könnte als zweite Methode anstelle des A-Posteriori-Verfahrens das Consecutive Bits Verfahren verwendet werden, oder auch die Reihenfolge der zweiten, dritten und weiteren Methode geändert werden, wobei es vorteilhaft ist, die anzuwendenden Methoden nach dem Berechnungsaufwand zu Reihen.

## Patentansprüche

1. Verfahren zur Rekonstruktion eines fehlerhaft empfangenen Datenpakets (DP), das in einem drahtlosen Sensornetzwerk (1) von einem Funkknoten (FK) in Form von Datenfeldern (DF), die vorab bekannte Information enthalten, an eine Empfangseinheit (2) gesendet wurde, **dadurch gekennzeichnet, dass**
- in der Empfangseinheit (2) eine erste und eine zweite Methode zur Rekonstruktion des fehlerhaft empfangenen Datenpakets (DP) unter Verwendung der in den Datenfeldern (DF) enthaltenen vorab bekannten Information implementiert werden,
- in einem ersten Schritt die erste Methode zur Rekonstruktion des fehlerhaft empfangenen Datenpakets (DP) angewendet wird und dabei überprüft wird, ob damit das Datenpaket (DP) rekonstruiert wurde, und
- in einem folgenden zweiten Schritt die zweite Methode zur Rekonstruktion des fehlerhaft empfangenen Datenpakets (DP) angewendet wird, falls das fehlerhaft empfangene Datenpaket (DP) mit der ersten Methode nicht rekonstruiert wurde, und dabei überprüft wird, ob damit das Datenpaket (DP) rekonstruiert wurde.

2. Verfahren nach Anspruch 1, **dadurch gekennzeichnet, dass** in zumindest einem weiteren folgenden Schritt eine weitere, in der Empfangseinheit (2) implementierte Methode zur Rekonstruktion des fehlerhaft empfangenen Datenpakets (DP) angewendet wird, falls das fehlerhaft empfangene Datenpaket (DP) mit der zweiten Methode nicht rekonstruiert wurde, und dabei überprüft wird, ob damit das Datenpaket (DP) rekonstruiert wurde.

3. Verfahren nach Anspruch 1 oder 2, **dadurch gekennzeichnet, dass** bei der ersten Methode der Wert zumindest eines Bits eines Datenfeldes (DF) des Datenpakets (DP) bekannt ist und im fehlerhaft empfangenen Datenpaket (DP) dieses zumindest eine Bit geändert wird und dabei überprüft wird, ob mit dieser Änderung das Datenpaket (DP) rekonstruiert wurde.

4. Verfahren nach Anspruch 1 oder 2, **dadurch gekennzeichnet, dass** bei der zweiten Methode aus dem fehlerhaft empfangenen Datenpaket (DP) der erwartete Wert zumindest eines Bits eines Datenfeldes (DF) abgeleitet wird und dieses zumindest eine Bit im fehlerhaft empfangenen Datenpaket (DP) geändert wird und dabei überprüft wird, ob mit dieser Änderung das Datenpaket (DP) rekonstruiert wurde.

5. Verfahren nach Anspruch 1 oder 2, **dadurch gekennzeichnet, dass** bei der zweiten oder bei der weiteren Methode ein Fehlerblock (FB) mit einer Länge (i) von Bits schrittweise über zumindest einen Teil des fehlerhaft empfangenen Datenpakets (DP) geschoben wird und in jedem Schritt alle im Fehlerblock (FB) liegenden Bits invertiert werden und in jedem Schritt überprüft wird, ob mit dieser Änderung das Datenpaket (DP) rekonstruiert wurde.

6. Verfahren nach Anspruch 5, **dadurch gekennzeichnet, dass** in jedem Schritt die im Fehlerblock (FB) liegenden Bits durchiteriert werden und dabei jeweils überprüft wird, ob mit dieser Änderung das Datenpaket (DP) rekonstruiert wurde.

7. Verfahren nach Anspruch 1 oder 2, **dadurch gekennzeichnet, dass** bei der zweiten oder bei der weiteren Methode zumindest zwei fehlerhaft empfangene Datenpakete (DP1, DP1') miteinander verglichen werden und Bitpositionen ermittelt werden, an denen sich die beiden Datenpakete (DP1, DP1') unterscheiden und die Bits an zumindest einer dieser Bitpositionen schrittweise durchiteriert werden und dabei in jedem Schritt überprüft wird, ob mit dieser Änderung das Datenpaket (DP1) rekonstruiert wurde.

8. Verfahren nach Anspruch 7, **dadurch gekennzeichnet, dass** um die Bitposition ein Bitbereich (BB) mit einer Anzahl von Bits vor und/oder eine Anzahl von Bits nach der Bitposition definiert wird und die Bits im Bitbereich (BB) schrittweise durchiteriert werden und dabei in jedem Schritt überprüft wird, ob mit dieser Änderung das Datenpaket (DP1) rekonstruiert wurde.

## Claims

1. A method for reconstructing an incorrectly received data packet (DP) that has been transmitted in a wireless sensor network (1) from a wireless node (FK) in form of data fields (DF), which contain information that is known in advance, to a receiving unit (2), **characterized in that**
- a first method and a second method for reconstructing the incorrectly received data packet (DP) are implemented in the receiving unit (2) by using the information known in advance which is contained in the data fields (DF),
- in a first step, the first method for reconstructing the incorrectly received data packet (DP) is applied and a check is made for whether the data packet (DP) has thus been reconstructed, and
- in a subsequent second step, the second method for reconstructing the incorrectly received data packet (DP) is applied if the incorrectly received data packet (DP) has not been reconstructed with the first method, and a check is made for whether the data packet (DP) has thus been reconstructed.

2. The method according to Claim 1, **characterized in that** in at least one further subsequent step, a further method, implemented in the receiving unit (2), for reconstructing the incorrectly received data packet (DP) is applied if the incorrectly received data packet (DP) has not been reconstructed with the second method, and a check is made for whether the data packet (DP) has thus been reconstructed.

3. The method according to Claim 1 or 2, **characterized in that** in the first method, the value of at least one bit of a data field (DF) of the data packet (DP) is known, and in the incorrectly received data packet (DP) this at least one bit is modified, and a check is made for whether the data packet (DP) has been reconstructed due to this modification.

4. The method according to Claim 1 or 2, **characterized in that** in the second method, the expected value of at least one bit of a data field (DF) is derived from the incorrectly received data packet (DP), and this at least one bit in the incorrectly received data packet (DP) is modified, and a check is made for whether the data packet (DP) has been reconstructed due to this modification.

5. The method according to Claim 1 or 2, **characterized in that** in the second method or in the further method, an error block (FB) having a length (i) of bits is shifted step by step over at least a portion of the incorrectly received data packet (DP), and in each step all bits present in the error block (FB) are inverted, and in each step a check is made for whether the data packet (DP) has been reconstructed due to this modification.

6. The method according to Claim 5, **characterized in that** in each step the bits present in the error block (FB) are reiterated, and in each case a check is made for whether the data packet (DP) has been reconstructed due to this modification.

7. The method according to Claim 1 or 2, **characterized in that** in the second method or in the further method, at least two incorrectly received data packets (DP1, DP1') are compared to one another, and bit positions are identified at which the two data packets (DP1, DP1') differ, and the bits are reiterated step by step at at least one of these bit positions, and in each step a check is made for whether the data packet (DP1) has been reconstructed due to this modification.

8. The method according to Claim 7, **characterized in that** a bit range (BB) is defined around the bit position, with a number of bits before the bit position and/or a number of bits after the bit position, and the bits in the bit range (BB) are reiterated step by step, and in each step a check is made for whether the data packet (DP1) has been reconstructed due to this modification.

## Revendications

1. Procédé permettant de reconstruire un paquet de données (DP) reçu de manière erronée qui a été envoyé d'un noeud radio (FK) vers une unité de réception (2), dans un réseau de capteurs (1), sous la forme de champs de données (DF) qui contiennent au préalable l'information connue, **caractérisé en ce que**
- une première et une deuxième méthode permettant de reconstruire le paquet de données (DP) reçu de manière erronée sont implémentées dans l'unité de réception (2) en utilisant l'information connue au préalable qui est contenue dans les champs de données (DF),
- la première méthode permettant de reconstruire le paquet de données (DP) reçu de manière erronée est appliquée au cours d'une première étape, un contrôle étant alors effectué afin de déterminer si ladite méthode a permis de reconstruire le paquet de données (DP), et
- la deuxième méthode permettant de reconstruire le paquet de données (DP) reçu de manière erronée est appliquée au cours d'une deuxième étape, si le paquet de données (DP) reçu de manière erronée n'a pas été reconstruit avec la première méthode, un contrôle étant alors effectué afin de déterminer si ladite méthode a permis de reconstruire le paquet de données (DP).

2. Procédé selon la revendication 1, **caractérisé en ce qu'**une autre méthode implémentée dans l'unité de réception (2) et permettant de reconstruire le paquet de données (DP) reçu de manière erronée est appliquée au cours d'une deuxième étape consécutive minimum, si le paquet de données (DP) reçu de manière erronée n'a pas été reconstruit avec la deuxième méthode, un contrôle étant alors effectué afin de déterminer si ladite méthode a permis de reconstruire le paquet de données (DP).

3. Procédé selon la revendication 1 ou 2, **caractérisé en ce que**, pour la première méthode, la valeur d'au moins un bit d'un champ de données (DF) du paquet de données (DP) est connue et que ledit bit est modifié d'au moins un bit dans le paquet de données (DP) reçu de manière erronée, un contrôle étant alors effectué afin de déterminer si ladite modification a permis de reconstruire le paquet de données (DP).

4. Procédé selon la revendication 1 ou 2, **caractérisé en ce que**, pour la deuxième méthode, la valeur attendue d'au moins un bit d'un champ de données (DF) du paquet de données (DP) reçu de manière erronée est dérivée et que ledit bit est modifié d'au moins un bit dans le paquet de données (DP) reçu de manière erronée, un contrôle étant alors effectué afin de déterminer si ladite modification a permis de reconstruire le paquet de données (DP).

5. Procédé selon la revendication 1 ou 2, **caractérisé en ce que**, pour la deuxième méthode ou les suivantes, un bloc erroné (FB) avec une longueur (i) de bits est décalé graduellement sur au moins une partie du paquet de données (DP) reçu de manière erronée et que tous les bits situés dans le bloc erroné (FB) sont inversés et contrôlés à chaque étape afin de déterminer si ladite modification a permis de reconstruire le paquet de données (DP).

6. Procédé selon la revendication 5, **caractérisé en ce que** les bits situés dans le bloc erroné (FB) sont itérés à chaque étape, un contrôle étant alors effectué à chaque fois afin de déterminer si ladite modification a permis de reconstruire le paquet de données (DP).

7. Procédé selon la revendication 1 ou 2, **caractérisé en ce que**, pour la deuxième méthode ou les suivantes, au moins deux paquets de données (DP1, DP1') reçus de manière erronée sont comparés l'un avec l'autre et que les positions de bits où les deux paquets de données (DP1, DP1') se distinguent sont déterminées, et que les bits sont itérés graduellement au moins au niveau de l'une desdites positions de bits, un contrôle étant alors effectué à chaque étape afin de déterminer si ladite modification a permis de reconstruire le paquet de données (DP1).

8. Procédé selon la revendication 7, **caractérisé en ce qu'**une plage de bits (BB) comprenant un nombre de bits qui se trouve en amont et/ou en aval de la position de bits est définie autour des positions de bits et que les bits se trouvant dans la plage de bits (BB) sont itérés graduellement, un contrôle étant alors effectué à chaque étape afin de déterminer si ladite modification a permis de reconstruire le paquet de données (DP1).
